(19) Europäisches Patentamt
European Patent Office
Office européen des brevets

(11) Veröffentlichungsnummer: **0 324 059**
**A2**

(12) **EUROPÄISCHE PATENTANMELDUNG**

(21) Anmeldenummer: **88114588.2**

(22) Anmeldetag: **07.09.88**

(51) Int. Cl.4: **G03F 7/10 , G03C 1/72 , //C07F7/18**

(30) Priorität: **13.09.87 DE 3730783**

(43) Veröffentlichungstag der Anmeldung: **19.07.89 Patentblatt 89/29**

(84) Benannte Vertragsstaaten: **AT DE FR GB IT NL**

(71) Anmelder: **HOECHST AKTIENGESELLSCHAFT
Postfach 80 03 20
D-6230 Frankfurt am Main 80(DE)**

(72) Erfinder: **Dössel, Karl-Friedrich, Dr.
Fritz-Kalle-Strasse 8
D-6200 Wiesbaden(DE)**

(54) **Positiv arbeitendes strahlungsempfindliches Gemisch und daraus hergestelltes strahlungsempfindliches Aufzeichnungsmaterial.**

(57) Es wird ein positiv arbeitendes strahlungsempfindliches Gemisch vorgeschlagen, welches eine Verbindung, die unter Einwirkung von aktinischer Strahlung eine Säure bildet, sowie eine Verbindung, die durch Säure spaltbar ist, enthält, und das dadurch gekennzeichnet ist, daß die Verbindung, die durch Säure spaltbar ist, eine Silylenolethergruppierung aufweist.

Das beschriebene strahlungsempfindliche Gemisch weist eine verbesserte Lagerfähigkeit als der Stand der Technik und eine hohe Strukturauflösung auf.

EP 0 324 059 A2

Xerox Copy Centre

## Positiv arbeitendes strahlungsempfindliches Gemisch und daraus hergestelltes strahlungsempfindliches Aufzeichnungsmaterial

Die Erfindung betrifft ein positiv arbeitendes strahlungsempfindliches Gemisch, enthaltend eine Verbindung, die unter Einwirkung von aktinischer Strahlung eine Säure bildet, sowie eine Verbindung, die durch Säure spaltbar ist.

Positiv arbeitende strahlungsempfindliche Gemische, bei denen durch Einwirkung von aktinischer Strahlung auf einen Photoinitiator eine Säure gebildet wird und diese dann in einer Sekundärreaktion ein säurespaltbares Material in den bestrahlten Bereichen in einem entsprechenden Entwickler löslich macht, sind seit langem bekannt.

Unter den bisher auf diesem Gebiet eingesetzten säurespaltbaren Materialien haben sich bewährt:

a) solche mit mindestens einer Orthocarbonsäureester- und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,

b) Oligomer- oder Polymerverbindungen mit wiederkehrenden Acetal- und/oder Ketalgruppierungen in der Hauptkette,

c) Verbindungen mit mindestens einer Enolether- oder N-Acyliminocarbonatgruppierung,

d) cyclische Acetale oder Ketale von ß-Ketoestern oder -amiden und

e) Verbindungen mit Silylethergruppierungen.

Durch Säure spaltbare Verbindungen des Typs a) als Komponenten strahlungsempfindlicher Gemische sind in der EP-A-0 022 571 und der DE-A-26 10 842 ausführlich beschrieben; Gemische, die Verbindungen des Typs b) enthalten, sind in der DE-C-23 06 248 und der DE-C-27 18 254 beschrieben; Verbindungen des Typs c) werden in den EP-A-0 006 626 und 0 006 627 genannt, Verbindungen des Typs d) in der EP-A-0 202 196; Verbindungen, die dem Typ e) zuzurechnen sind, werden in den DE-A-35 44 165 und 36 01 264 vorgestellt.

Im Falle der Orthoester, der Amidoacetale, der Enolether oder der N-Acyliminocarbonsäuren konnten hohe Strahlungs- bzw. Lichtempfindlichkeiten erreicht werden. Jedoch besitzen derartige Verbindungen den Nachteil, daß sie eine schlechte Lagerfähigkeit zeigen.

Oligomer- oder Polymerverbindungen mit wiederkehrenden Acetal- und/oder Ketalgruppierungen in der Hauptkette besitzen zwar auch eine hohe Strahlungsempfindlichkeit, aufgrund ihrer Eigenschaft als Weichmacher für die Polymermatrix ist ihr Einsatzgebiet aber beschränkt. Hinzu kommen geringe Prozeßtoleranzen als Folge der Auswahl der Hydrolyseprodukte.

Die gleichen Unzulänglichkeiten werden auch bei polymeren, säurespaltbaren Materialien, die in der US-A-4 603 101 beschrieben sind, beobachtet. Die Monomeren, aus denen die dort genannten polymeren Materialien gebildet werden, sind tertiär substituierte Organomethylvinylarylether, insbesondere tert. Butyl-(vinylaryl)ether.

Um die Gesichtspunkte "Ätzresistenz" und "Spaltchemie" miteinander zu verknüpfen, wurden Verbindungen entwickelt, die säurespaltbare Silylethergruppierungen aufweisen. Diese zeigen aber eine verschlechterte Lagerbeständigkeit und eine merkliche Verschlechterung der Strahlungsempfindlichkeit.

Die Aufgabe der Erfindung war es daher, ein positiv arbeitendes strahlungsempfindliches Gemisch vorzuschlagen, welches eine verbesserte Lagerfähigkeit aufweist, einen guten Verarbeitungsspielraum, auch im Hinblick auf Ätzprozesse, bietet, hohe Strukturauflösungen ermöglicht sowie auch für kürzerwelliges Licht, z. B. Elektronen- oder Röntgenstrahlung, in photokatalytischen Resists eingesetzt werden kann.

Gelöst wird die Aufgabe durch Bereitstellen eines positiv arbeitenden strahlungsempfindlichen Gemisches, enthaltend eine Verbindung, die unter Einwirkung von aktinischer Strahlung eine Säure bildet sowie eine Verbindung, die durch Säure spaltbar ist, dadurch gekennzeichnet, daß diese Verbindung einen Silylenolether der allgemeinen Formel I

$$\begin{array}{ccccccccccccc} & & R_1 & & & & & & & & & & \\ & & | & & & & & & & & & & \\ R_3 & - & Si & - & O & - & C & = & C & - & R_6 & & \\ & & | & & & & | & & | & & & & \\ & & R_2 & & & & R_4 & & R_5 & & & & \end{array} \qquad (I)$$

enthält, worin

$R_1$ und $R_2$ gleich oder verschieden sind und Alkyl, Cycloalkyl oder Aryl,

$R_3$ Alkyl, Cycloalkyl, Aryl oder -O-$R_7$, $R_4$, $R_5$ und $R_6$ gleich oder verschieden sind und Wasserstoff, Alkyl, Cycloalkyl, Alkenyl, Cycloalkenyl oder Aryl, sowie

$R_7$ Wasserstoff, Alkyl, Cycloalkyl, Alkenyl, Cycloalkenyl, Aryl oder Silyl

bedeuten. Insbesondere sind

$R_1$ und $R_2$ gleich oder verschieden und ($C_1$-$C_3$)Alkyl, vorzugsweise Methyl, $C_5$- oder $C_6$-Cycloalkyl oder ($C_6$-$C_{10}$)Aryl, vorzugsweise Phenyl;

$R_3$ ($C_1$-$C_6$)Alkyl, vorzugsweise Methyl, $C_5$- oder $C_6$-Cycloalkyl, ($C_6$-$C_{10}$)Aryl, vorzugsweise Phenyl oder -O-$R_7$;

$R_4$, $R_5$ und $R_6$ gleich oder verschieden und Wasserstoff, ($C_1$-$C_3$)Alkyl, Alkenyl, Cycloalkenyl oder Aryl, wobei die C-C-Doppelbindungen in diesen Resten vorzugsweise in Konjugation stehen zu der Doppelbindung in -$CR_4$ = $CR_5$- sowie ($C_1$-$C_6$)Alkenyl und $C_5$- oder $C_6$-Cycloalkenyl vorzugsweise nur eine Doppelbindung zur Konjugation bereitstellen;

Aryl vorzugsweise Phenyl ist, ggf. substituiert durch Alkyl, Alkoxy, Halogen und Hydroxy, sowie ggf. verethert mit Alkyl- bzw. Arylhalogensilanen;

$R_7$ ($C_1$-$C_6$)Alkyl, ($C_5$-$C_{10}$)Cycloalkyl, ($C_1$-$C_6$)Alkenyl, ($C_5$-$C_{10}$)Cycloalkenyl sowie ($C_6$-$C_{10}$)Aryl, insbesondere Phenyl, oder Silyl.

Besonders bevorzugt ist, wenn

$R_3$ gleich -O-$R_7$ ist und darin

$R_7$ -$CR_4$ = $CR_5$-$R_6$ bedeutet, sowie daneben

$R_1$ und $R_2$ nur dann gleich sind, wenn sie ($C_1$-$C_3$)Alkyl, vorzugsweise Methyl sind.

Sind $R_1$ und $R_2$ verschieden, so ist insbesondere nur $R_1$ $C_5$- oder $C_6$-Cycloalkyl oder ($C_6$-$C_{10}$)Aryl, vorzugsweise Phenyl.

Insbesondere in diesem Fall ist auch bevorzugt, wenn

$R_4$ und $R_5$ zu einem cycloaliphatischen Ring geschlossen sind, so daß sich ein Cyclopentenyl- oder ein Cyclohexenylring bildet;

$R_6$ ist in diesem Fall vorzugsweise Wasserstoff, kann aber auch Aryl oder Alkenyl bedeuten, insbesondere wenn deren Doppelbindungen in Konjugation zu -$CR_4$ = $CR_5$- stehen.

Ebenso bevorzugt ist, wenn

$R_3$ ungleich -O-$R_7$ ist und

$R_1$ und $R_2$ vorzugsweise gleich, ($C_1$-$C_3$)Alkyl, $C_5$- oder $C_6$-Cycloalkyl oder ($C_6$-$C_{10}$)Aryl, vorzugsweise Phenyl bedeuten.

In diesem Fall wird ganz besonders bevorzugt, wenn $R_1$, $R_2$ und $R_3$ in maximal nur zwei Resten, insbesondere in $R_1$ und $R_2$ einen cyclischen, vorzugsweise einen Cycloalkyl- oder Phenylrest bedeuten und $R_3$ ($C_1$-$C_6$)Alkyl ist.

$R_5$ und $R_6$ können insbesondere in diesem Fall Wasserstoff bedeuten,

$R_4$ ist dann vorzugsweise ein Alkenyl, Cycloalkyl, vorzugsweise ein Phenyl, besonders bevorzugt, wenn substituiert durch einen Silyletherrest, insbesondere in ortho- oder para-Stellung, wobei dessen Substituenten insbesondere mit $R_1$, $R_2$ und $R_3$ übereinstimmen.

Oder aber

$R_4$ und $R_5$ sind zu einem cycloaliphatischen Ring geschlossen, so daß sich ein Cyclopentenyl- oder ein Cyclohexenylring bildet,

$R_6$ ist in diesem Fall bevorzugt Wasserstoff, kann aber auch Alkenyl oder Aryl bedeuten, in denen vorzugsweise die Doppelbindungen in Konjugation zu -$CR_4$ = $CR_5$- stehen.

Die in den erfindungsgemäßen strahlungsempfindlichen Gemischen enthaltenen Silylenoletherverbindungen können sowohl monomere Verbindungen als auch Polymere sein. Im Falle der Polymeren müssen sowohl die Halogensilane zumindest bifunktionell sein, d.h. zumindest zwei Halogenatome enthalten, als auch die zur Reaktion gebrachten Aldehyde bzw. Ketone zumindest zwei Carbonylgruppen aufweisen. Bevorzugt werden allerdings Monomere, zu denen sowohl Umsetzungsprodukte aus 1 mol Halogensilan mit 1 mol Aldehyd bzw. Keton, aber auch Produkte aus 1 mol einer bi- oder trifunktionellen Halogensilanverbindung mit 2 bzw. 3 mol eines Aldehyds bzw. Ketons zählen.

Die säurespaltbaren Silylenoletherverbindungen können intramolekular zusätzlich säurespaltbare Silylethergruppen enthalten, vorzugsweise in einem Verhältnis von 1:1 zueinander. Es können aber auch reine Silylenoletherverbindungen in Mischung mit Silyletherverbindungen eingesetzt werden. In diesem Fall ist bevorzugt, wenn ein Molverhältnis von 0,1:1 bis 0,5:1 (Silyletherverbindung: Silylenoletherverbindung) vorliegt. Ganz besonders bevorzugt ist allerdings die nicht verschnittene reine Silylenoletherverbindung.

Der Gehalt an Silylenoletherverbindungen, einschließlich solcher Verbindungen, die zusätzliche Silylethergruppen enthalten, sowie auch Verbindungen, die in Mischung mit reinen Silyletherverbindungen vorliegen, liegt im allgemeinen bei 2 bis 50 Gew.-%, vorzugsweise bei 10 bis 25 Gew.-%, jeweils bezogen

auf das Gesamtgewicht des Gemisches.

Für das erfindungsgemäße strahlungsempfindliche Gemisch kommen als Komponenten, die beim Bestrahlen vorzugsweise eine starke Säure bilden bzw. abspalten, eine große Anzahl von Verbindungen und Mischungen derselben in Frage. Zu nennen sind Diazonium-, Phosphonium-, Sulfonium- und Iodonium-Salze, Halogenverbindungen, o-Chinondiazidsulfochloride und -ester sowie Organometall-Organohalogen-Kombinationen.

Die genannten Diazonium-, Phosphonium-, Sulfonium- und Iodonium-Verbindungen werden in der Regel eingesetzt in Form ihrer in organischen Lösungsmitteln löslichen Salze, meist als Abscheidungsprodukt mit komplexen Säuren wie Borfluorwasserstoffsäure, Hexafluorphosphor-, Hexafluorantimon- und -arsensäure. U.a. werden diese Verbindungen auch in der DE-A-36 01 264 genannt.

Unter die Halogenverbindungen zählen insbesondere Triazinderivate, die aus den US-A-3 515 552, 3 536 489 und 3 779 778 sowie den DE-C-27 18 259, 33 37 024, 33 33 450, 23 06 248, 22 43 621 und 12 98 414 bekannt sind. Diese können aber auch in Kombination mit anderen Photoinitiatoren wie Oxazolen, Oxadiazolen oder Thiazolen, aber auch untereinander in Mischungen eingesetzt werden.

Es sind aber auch Oxazole, Oxadiazole, Thiazole oder 2-Pyrone bekannt, die Trichlor- oder Tribrommethylgruppen enthalten (DE-A-30 21 599, 30 21 590, 28 51 472, 29 49 396 sowie EP-A-0 135 348 und 0 135 863).

Ebenso zählen unter diesen Oberbegriff insbesondere auch aromatische Verbindungen, die kernständiges Halogen, vorzugsweise Brom aufweisen. Solche Verbindungen sind aus der DE-A-26 10 842 bekannt oder werden in der gleichzeitig eingereichten Patentanmeldung P 37 30 784.3 beschrieben.

Als Vertreter einer Kombination mit einem Thiazol sei eine mit 2-Benzoylmethylen-naphtho [1,2-d] thiazol genannt (DE-A-28 51 641 und DE-A-29 34 758). Ein Gemisch einer Trihalogenmethylverbindung mit N-Phenylacridon ist aus der DE-A-26 10 842 bekannt.

Ebenso stehen α-Halogencarbonsäureamide (DE-A-27 18 200) oder Tribrommethyl-phenylsulfone (DE-A-35 03 113), die z.B. durch Benzophenon, Benzil oder Michlers Keton sensibilisiert werden können, zur Verfügung.

In der Regel können aber alle beschriebenen licht- bzw. strahlungsempfindlichen Verbindungen durch Photosensibilisatoren in ihrer Effektivität unterstützt werden. Zu nennen sind z.B. Anthracen, Phenanthren, Pyren, 1,2-Benzanthren, Thiazine, Pyrazoline, Benzofurane, Benzophenone, Fluorenone, Anthrachinone sowie Cumarinderivate. Ihr Gehalt liegt bei 0,01 bis 5 Gew.-%, bezogen auf das Gewicht des strahlungsempfindlichen Gemisches.

Besonders bevorzugt sind vor allem Triazinderivate sowie aromatische Verbindungen mit kernständigem Halogen, insbesondere Brom, aus der DE-A-26 10 842 sowie der gleich zeitig eingereichten Patentanmeldung P 37 30 784.3.

Vorzugsweise werden diese Verbindungen erst bei energiereicher, d.h. kürzerwelliger Strahlung gespalten. Hierunter zählt vor allem neben UV-Strahlung Elektronen- oder Röntgenstrahlung.

Neben monomeren strahlungsempfindlichen Verbindungen können auch Polymere dieser Art eingesetzt werden. Bei Verwendung von monomeren Startern liegt deren Gehalt im Bereich von 0,01 bis 30 Gew.-%, insbesondere von 0,4 bis 20 Gew.-%, bezogen auf das Gewicht der strahlungsempfindlichen Mischung.

Werden polymere Starter verwendet, so kann ggf. auf ein polymeres Bindemittel verzichtet werden. Dies hat zur Folge, daß dessen Gehalt in Abhängigkeit von seinem Anteil am Gehalt des Polymeren in dieser Mischung auch über den beschriebenen Bereich bei monomeren Startern hinausgehen kann. Insbesondere werden Gehalte von größer als 50 Gew.-% und bis zu 100 Gew.-%, abzüglich des Gehaltes der Verbindung, die durch Säure spaltbar ist, in Anspruch genommen.

Das erfindungsgemäße strahlungsempfindliche Gemisch enthält ferner ggf. ein in Wasser unlösliches, in organischem Lösemittel und Alkali aber lösliches, zumindest quellbares Bindemittel. Hierunter zählen vor allem Phenolharze vom Novolak-Typ. Genannt werden Phenol-Formaldehyd-Harze, Kresol-Formaldehydharze, deren Mischkondensate und deren Mischungen.

Daneben können auch Vinylpolymerisate wie Polyvinylacetale, Polymethacrylate, Polyacrylate, Polyvinylether, Polyvinylpyrrolidone sowie Styrolpolymerisate, jeweils ggf. durch Comonomere modifiziert, allein oder in Mischung mit anderen, eingesetzt werden.

Im besonderen sind zu nennen: Polymere von Styrol mit Einheiten von Alkenylsulfonylaminocarbonyloxy- oder Cycloalkenylsulfonylaminocarbonyloxy- (EP-A-0 184 804), Polymere der Acryl-, Methacryl-, Malein-, Itaconsäure etc. mit seitenständigen, vernetzenden -$CH_2OR$-Gruppen (EP-A-0 184 044), Polymerisate aus Vinylmonomeren mit Alkenylphenoleinheiten (EP-A-0 153 682), Polyvinylphenole als Novolakersatz (DE-C-23 22 230), polymere Bindemittel mit seitenständigen, phenolischen Hydroxylgruppen (EP-A-0 212 439 und 0 212 440), Styrol-Maleinsäureanhydrid-Mischpolymerisate (DE-A-31 30 987), Polymere aus ungesättigten (Thio)phosphinsäureiso(thio)cyanaten mit einem aktiven Wasserstoff enthaltenden

Polymeren (deutsche Patentanmeldungen P 36 15 612.4 und P 36 15 613.2), Polymere mit Vinylacetat-, Vinylalkohol- und Vinylacetaleinheiten (EP-A-0 216 083) sowie Polyvinylacetale mit Einheiten aus Hydroxyaldehyden (deutsche Patentanmeldung P 36 44 162.7).

Die Menge des Bindemittels beträgt im allgemeinen 1 bis 90, insbesondere 5 bis 90 Gew.-%, vorzugsweise 50 bis 90 Gew.-%, bezogen auf das Gesamtgewicht der strahlungsempfindlichen Mischung.

Ferner können den erfindungsgemäßen strahlungsempfindlichen Gemischen ggf. Farbstoffe, Pigmente, Weichmacher, Netzmittel und Verlaufmittel, aber auch Polyglykole, Celluloseether, z.B. Ethylcellulose, zur Verbesserung spezieller Eigenschaften wie Flexibilität, Haftung und Glanz zugesetzt werden.

Vorzugsweise wird das erfindungsgemäße strahlungsempfindliche Gemisch in Lösungsmitteln wie Ethylenglykol, Glykolethern wie Glykolmonomethylether, Glykoldimethylether, Glykolmonoethylether oder Propylenglykolmonoalkylethern, insbesondere Propylenglykolmethylether; aliphatischen Estern wie Ethylacetat, Hydroxyethylacetat, Alkoxyethylacetat, n-Butylacetat, Propylenglykolmonoalkyletheracetat, insbesondere Propylenglykolmethyletheracetat oder Amylacetat; Ethern wie Dioxan, Ketonen wie Methylethylketon, Methyliso-butylketon, Cyclopentanon und Cyclohexanon; Dimethylformamid, Dimethylacetamid, Hexamethylphosphorsäureamid, N-Methyl-pyrrolidon, Butyrolacton, Tetrahydrofuran, und in Mischungen derselben gelöst. Besonders bevorzugt werden Glykolether, aliphatische Ester sowie Ketone.

Die mit den übrigen Bestandteilen des strahlungsempfindlichen Gemisches entstehenden Lösungen haben in der Regel einen Feststoffgehalt von 5 bis 60 Gew.-%, vorzugsweise bis 50 Gew.-%.

Erfindungsgemäß wird ferner ein strahlungsempfindliches Aufzeichnungsmaterial beansprucht, im wesentlichen be stehend aus einem Substrat und dem darauf aufgetragenen strahlungsempfindlichen Gemisch.

Als Substrate kommen alle Materialien in Frage, aus denen Kondensatoren, Halbleiter, mehrlagige gedruckte Schaltungen oder integrierte Schaltkreise bestehen bzw. hergestellt werden können. Insbesondere sind Oberflächen aus thermisch oxidiertem und/oder mit Aluminium beschichtetem Siliciummaterial zu nennen, die gegebenfalls auch dotiert sein können, einschließlich aller anderen in der Halbleitertechnologie üblichen Substrate wie beispielsweise Siliciumnitrid, Galliumarsenid, Indiumphosphid. Weiterhin kommen in Frage die aus der Flüssigkristalldisplay-Herstellung bekannten Substrate wie Glas, Indium-Zinnoxid; ferner Metallplatten und -folien, beispielsweise aus Aluminium, Kupfer, Zink; Bimetall- und Trimetallfolien, aber auch elektrisch nicht leitende Folien, die mit Metallen bedampft sind, gegebenenfalls mit Aluminium beschichtete $SiO_2$-Materialien und Papier. Diese Substrate können einer Temperatur-Vorbehandlung unterzogen werden, oberflächlich angerauht, angeätzt oder zur Erzielung erwünschter Eigenschaften, wie z. B. Erhöhung der Hydrophilie, mit Chemikalien behandelt sein.

In einer besonderen Ausführungsform kann das strahlungsempfindliche Gemisch zur besseren Haftung in dem Resist oder zwischen dem Resist und dem Substrat einen Haftvermittler enthalten. Bei Silicium- bzw. Siliciumdioxid-Substraten kommen hierfür Haftvermittler vom Aminosilan- Typ, wie z.B. 3-Aminopropyltriethoxysilan oder Hexamethyl-disilazan in Frage.

Beispiele für Träger, die zur Herstellung von photomechanischen Aufzeichnungsmaterialien wie Druckformen für den Hochdruck, den Flachdruck, den Siebdruck, den Tiefdruck sowie von Reliefkopien Verwendung finden können, sind Aluminiumplatten, ggf. anodisch oxidiert, gekörnte und/oder silikatisierte Aluminiumplatten, Zinkplatten, Stahlplatten, die ggf. mit Chrom beschichtet wurden, sowie Kunststoffolien oder Papier.

Das erfindungsgemäße Aufzeichnungsmaterial wird bildmäßig bestrahlt. Quellen aktinischer Strahlung sind: Metallhalogenidlampen, Kohlebogenlampen, Xenonlampen und Quecksilberdampflampen. Bevorzugt wird eine Bestrahlung mit energiereicher Strahlung wie Laser-, Elektronen- oder Röntgenstrahlung. Als Laser werden insbesondere Helium/Neon-Laser, Argon-Laser, Krypton-Laser sowie Helium/Cadmium-Laser genannt.

Die Schichtstärke des strahlungsempfindlichen Gemisches variiert in Abhängigkeit von ihrem Einsatzgebiet. Sie beträgt zwischen 0,1 und 100 $\mu$m, insbesondere zwischen 1 und 10 $\mu$m.

Gegenstand der Erfindung ist ferner ein Verfahren zur Herstellung eines strahlungsempfindlichen Aufzeichnungsmaterials. Das Auftragen des strahlungsempfindlichen Gemisches auf das Substrat kann durch Aufsprühen, Fließbeschichten, Walzen, Schleuderbeschichten und Tauchbe schichten erfolgen. Danach wird das Lösungsmittel durch Verdampfen entfernt, so daß auf der Oberfläche des Substrates die strahlungsempfindliche Schicht zurückbleibt. Die Entfernung des Lösemittels kann gegebenfalls durch Erhitzen der Schicht auf Temperaturen von bis zu 150° C gefördert werden. Das Gemisch kann aber auch zunächst auf obengenannte Weise auf einen Zwischenträger aufgetragen werden, von dem aus es unter Druck und erhöhter Temperatur auf das endgültige Trägermaterial übertragen wird.

Anschließend wird die Schicht bildmäßig bestrahlt. Üblicherweise wird aktinische Strahlung verwendet, besonders bevorzugt sind UV-, Röntgen- oder Elektronenstrahlung. Üblicherweise werden zur Bestrahlung

UV-Lampen verwendet, die Strahlung einer Wellenlänge von 200 bis 500 nm mit einer Intensität von 0,5 bis 60 $mW/cm^2$ aussenden. In der strahlungsempfindlichen Schicht wird anschließend durch Entwicklung ein Bildmuster freigelegt, in dem die Schicht mit einer Entwicklungslösung behandelt wird, die die bestrahlten Bereiche des Materials löst bzw. entfernt.

Als Entwickler werden Lösungen von alkalischen Reagenzien wie z.B. Silikaten, Metasilikaten, Hydroxiden, Hydrogen- bzw. Dihydrogenphosphaten, Carbonaten bzw. Hydrogencarbonaten, insbesondere von Alkali- oder Ammoniumionen, aber auch Ammoniak, organische Ammoniumhydroxide und dergleichen verwendet. Der Gehalt dieser Substanzen in der Entwicklerlösung beträgt im allgemeinen 0,1 bis 15 Gew.-%, vorzugsweise 0,5 bis 5 Gew.-%, bezogen auf das Gewicht der Entwicklerlösung.

Zur Erhöhung der Resistenz gegen mechanische und chemische Einflüsse, insbesondere gegen Ätzmedien, können die entwickelten Schichten noch einige Zeit, z.B. 5 bis 40 Minuten, auf erhöhte Temperatur, z.B. oberhalb 100° C, erhitzt werden, wobei diese Wirkung noch durch Belichten mit UV-Strahlung unterstützt werden kann.

Die Herstellung der in den erfindungsgemäßen strahlungsempfindlichen Gemischen verwendeten Silylenolether kann in der folgenden Weise vorgenommen werden: Im Prinzip geht man aus von einem Aldehyden bzw. Keton, der bzw. das mit einem entsprechenden Chlorsilan umgesetzt wird. Bei Umsetzungen mit Dichlorsilanen können Bis-Silylenolether, mit Trichlorsilanen bzw. Tetrachlorsilanen auch entsprechend höhere Silylenolether, synthetisiert werden, die ebenso in den erfindungsgemäßen strahlungsempfindlichen Gemischen Anwendung finden können. Das folgende Beispiel soll die Herstellungsmethode noch genauer umreißen:

<u>Herstellung eines Bis-Silylenolethers (I)</u>

0,2 mol Dichlordimethylsilan und 0,6 mol Triethylamin wurden in 100 ml Dimethylformamid vorgelegt. Unter Rühren bei Raumtemperatur wurden 0,35 mol 2-Ethylbutyraldehyd zugetropft und anschließend 4 h unter Rühren auf 110° C erhitzt. Nach Abkühlen der Reaktionsmischung wurden 100 ml Hexan dazugegeben und mit Wasser gewaschen. Nach der Extraktion wurde die organische Phase einer fraktio nierten Destillation unterworfen. Dabei erhielt man 19 g des gewünschten Bis-Silylenolethers (Siedepunkt: 110 bis 113° C/15 Torr). Das NMR-Spektrum zeigte anhand von enolischen Protonen bei $\delta$ = 5,93 ppm, daß die Aldehydfunktionen vollständig in Silylenoletherfunktionen übergegangen waren.

Ebenso wurde ausgehend von Dichlor-dimethylsilan und 2-Methyl-cyclohexanon Verbindung II, von Dichlor-methylphenylsilan und Cyclopentanon Verbindung III, von Chlortrimethylsilan und p-Hydroxyacetophenon Verbindung IV, sowie von Chlor-diphenylmethylsilan und Cyclopentanon Verbindung V dargestellt. Die Analysenwerte der genannten Verbindungen sind in der folgenden Tabelle zusammengefaßt:

| | | Siedepunkt/Druck | NMR ( Vinyl) |
|---|---|---|---|
| I | 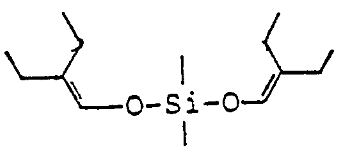 | 110-113° C/15 Torr | 5,93 ppm |
| II | 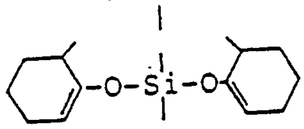 | 145° C/15 Torr | 4,92 ppm |
| III | 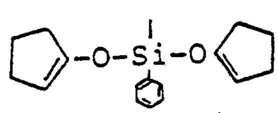 | 122° C/12 Torr | 4,78 ppm |
| IV | 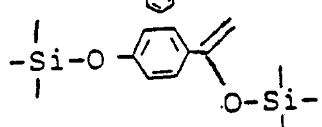 | 125° C/4 Torr | 4,19/4,65 ppm |
| V | 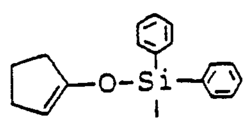 | 128°C/0,1 Torr | 4,56 ppm |

Die folgenden Anwendungsbeispiele sollen die Erfindung erläutern; Mengen sind darin in Gewichtsteilen (Gt) angegeben.

Beispiel 1

Es wurde eine Beschichtungslösung hergestellt, bestehend aus
4 Gt eines Kresol-Formaldehyd-Novolaks mit einem Erweichungspunkt von 105-120° C,
1 Gt des Bis-Silylenolethers (I) und
0,1 Gt 2-(2-Ethoxy-naphth-1-yl)-4,6-bis-trichlormethyl-s-triazin in
85 Gt Butanon.

Die Beschichtungslösung wurde in an sich bekannter Weise auf einen aus Aluminium bestehenden 0,3 mm dicken Druckplattenträger aufgetragen. Der Aluminiumträger war vorher elektrochemisch aufgerauht, anodisiert und mit Polyvinylphosphonsäure hydrophiliert worden. Nach dem Trocknen der Schicht wurde ein Schichtgewicht von 1,6 $g/m^2$ erhalten.

Die in dieser Weise hergestellte Offsetdruckplatte wurde mit einer Kopiervorlage, die einem Halbtonkeil, Mikrolinien von einer Stärke zwischen 4 und 75 µm und Rasterpunkte von 0,5 bis 5 % Flächendeckung enthielt, bedeckt. Anschließend wurde mit Strahlung einer Quecksilberhochdrucklampe (5 kW) 20 s in einem Abstand von 110 cm bestrahlt. Die Entwicklung der Offsetplatte erfolgte mit einem alkalischen Entwickler der Zusammensetzung:
5,3 Gt Natriummetasilikat x 9 $H_2O$,
3,4 Gt Trinatriumorthophosphat x 12 $H_2O$,
0,3 Gt Natriumdihydrogenphosphat und
136 Gt vollentsalztes Wasser.

Nach einer Entwicklungsdauer von 60 s konnte eine Druckform mit hoher Auflösung erhalten werden.

Beispiel 2

In diesem Beispiel wurde entsprechend dem Beispiel 1 verfahren; allerdings wurde als Silylenolether diesmal Verbindung II zu 1 Gt eingesetzt. Die entwickelte Offsetdruckplatte zeigte eine ebenso gute Auflösung wie die Druckplatte, die nach Beispiel 1 gewonnen werden konnte.

Beispiel 3

Es wurde eine Beschichtunglösung bestehend aus
18 Gt eines Kresol-Formaldehyd-Novolaks mit einem Erweichungspunkt von 105-120° C,
3 Gt des Bis-Silylenolethers (III) und
4 Gt Tetrabrom-Bisphenol A (Dow Chemical) in
74 Gt Propylenglykolmethyletheracetat
hergestellt.

Die Lösung wurde auf einen mit einem Haftvermittler (Hexamethyl-disilazan) behandelten Siliciumwafer bei 3.000 U/min aufgeschleudert. Nach der Trocknung bei 85° C für 30 min in einem Umluftofen wurde eine Schichtdicke von 1 µm erhalten.

Bildmäßig bestrahlt wurde mit Synchrotron-Strahlung (BESSY, Berlin, Luftspalt 2mm) einer Dosis von 35 $mJ/cm^2$ durch eine Gold-auf-Silicium-Maske. Den experi mentellen Aufbau dieser Bestrahlungsvariante findet man bei A. Heuberger, " X-Ray Lithography", Microelectronic Engineering 3, 535-556, (1985). Entwickelt wurde 30 s lang mit einem alkalischen Entwickler entsprechend Beispiel 1 bei 23° C. Alle Details konnten fehlerfrei auf das Bild übertragen werden, selbst wenn anstatt der 30 s Entwicklungszeit 60 s entwickelt wurde. Das Auflösungsvermögen ermöglichte, Linien von 0,3 µm zu erkennen.

Beispiel 4

Dieses Beispiel wurde entsprechend Beispiel 3 durchgeführt, nur daß anstelle der Verbindung III Verbindung IV in der gleichen Konzentration eingesetzt wurde. Die Ergebnisse entsprachen denjenigen, die auch in Beispiel 3 ermittelt werden konnten.

Beispiel 5

Entsprechend Beispiel 3 wurde ein Siliciumwafer mit einer strahlungsempfindlichen Lösung beschichtet, in diesem Beispiel allerdings mit Verbindung V als säurespaltbarem Material. Nach Trocknung in einem Umluftofen entsprechend Beispiel 3 wurde mit einem Elektronenstrahlschreiber bei einer Beschleunigungsspannung von 30 kV mit einer Strahlendosis von 0,5 µC/cm² bildmäßig bestrahlt.

Entwickelt wurde anschließend in einem handelsüblichen Entwickler entsprechend den vorbeschriebenen Beispielen für 30 s. Es konnte ein fehlerfreies Bild mit einer Auflösung von 0,3 µm erhalten werden.

Beispiel 6 (Vergleichsbeispiel)

Es wurde vorgegangen wie in Beispiel 1 mit dem Unterschied, daß anstelle des dort eingesetzten Silylenolethers ein polymerer Silylether (Verbindung 1-8 aus der DE-A-36 01 264) verwendet wurde. Bei einer Bestrahlungsdauer von 20 s konnte keine Differenzierung erzielt werden. Erst bei einer Erhöhung auf 260 s wurde eine Differenzierung zwischen bestrahlten und unbestrahlten Schichtteilen beobachtet. Aber auch in diesem Fall erwies sich die Entwicklerresistenz als unzureichend. Das beobachtete fladige Ablösen ließ zudem auf eine Unverträglichkeit zwischen dem Bindemittel und dem Polysilylether schließen und war auflösungsbegrenzend.

## Ansprüche

1. Positiv arbeitendes strahlungsempfindliches Gemisch, enthaltend eine Verbindung, die unter Einwirkung von aktinischer Strahlung eine Säure bildet, sowie eine Verbindung, die durch Säure spaltbar ist, dadurch gekennzeichnet, daß diese Verbindung eine Silylenolethergruppierung der allgemeinen Formel I

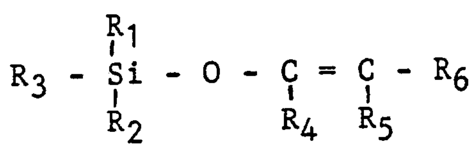

(I)

enthält, worin
$R_1$ und $R_2$ gleich oder verschieden sind und Alkyl, Cycloalkyl oder Aryl,
$R_3$ Alkyl, Cycloalkyl, Aryl oder -O-$R_7$,
$R_4$, $R_5$ und $R_6$ gleich oder verschieden sind und Wasserstoff, Alkyl, Cycloalkyl, Alkenyl, Cycloalkenyl oder Aryl sowie
$R_7$ Wasserstoff, Alkyl, Cycloalkyl, Alkenyl, Cycloalkenyl, Aryl oder Silyl
bedeuten.

2. Strahlungsempfindliches Gemisch nach Anspruch 1, dadurch gekennzeichnet, daß eine weitere Verbindung, die durch Säure spaltbar ist, enthalten ist.

3. Strahlungsempfindliches Gemisch nach Anspruch 2, dadurch gekennzeichnet, daß diese Verbindung eine Silylethergruppe trägt.

4. Strahlungsempfindliches Gemisch nach einem oder mehreren der Ansprüche 1 bis 3, dadurch gekennzeichnet, daß die Verbindung, die durch Säure spaltbar ist, monomer ist.

5. Strahlungsempfindliches Gemisch nach einem oder mehreren der Ansprüche 1 bis 4, dadurch gekennzeichnet, daß die Verbindung, die durch Strahlung eine Säure bildet, monomer ist.

6. Strahlungsempfindliches Gemisch nach Anspruch 5, dadurch gekennzeichnet, daß dieses Gemisch zusätzlich ein in Wasser unlösliches, in wäßrig-alkalischer Lösung aber lösliches Bindemittel enthält.

7. Positiv arbeitendes Aufzeichnungsmaterial, im wesentlichen bestehend aus einem Träger und einer strahlungsempfindlichen Schicht, dadurch gekennzeichnet, daß die Schicht aus einem strahlungsempfindlichen Gemisch gemäß den Ansprüchen 1 bis 6 hergestellt ist.

8. Verfahren zur Herstellung eines positiv arbeitenden Aufzeichnungsmaterials, dadurch gekennzeichnet, daß ein strahlungsempfindliches Gemisch gemäß den Ansprüchen 1 bis 6 auf einen ggf. mit einem Haftvermittler beaufschlagten Träger aufgebracht, das Material getrocknet wird, anschließend mit aktinischer

Strahlung bildmäßig bestrahlt und abschließend das Bild durch Entwickeln mit einem wäßrig-alkalischen Entwickler freigelegt wird.